# EUROPÄISCHE PATENTSCHRIFT

(11) **EP 2 854 486 B1**
(45) Veröffentlichungstag und Bekanntmachung des Hinweises auf die Patenterteilung: **07.06.2017**
(21) Anmeldenummer: 14003214.5
(22) Anmeldetag: 16.09.2014
(51) Int. Cl.: H05B 33/12, F21K 99/00, G09F 9/33, G09F 19/00, G09F 23/04, H01L 31/00, H01L 33/00, H02S 40/38, H01L 51/42, H01L 27/30, H01L 27/32, F21V 29/00, G09F 13/22, H01L 51/00, H01L 51/44

(54) **FLÄCHENELEMENT ZUM LEUCHTEN UND ERZEUGEN SOWIE SPEICHERN VON ENERGIE**
PLANAR ELEMENT FOR LIGHTS AND FOR CREATING AND STORING ENERGY
ÉLÉMENT DE SURFACE DESTINÉ À ÉCLAIRER, PRODUIRE ET EMMAGASINER DE L'ÉNERGIE

(30) Priorität: 30.09.2013 DE 102013016158
(43) Veröffentlichungstag der Anmeldung: 01.04.2015
(60) Teilanmeldung: 17000667.0
(73) Patentinhaber: FutureDynamics GmbH, 56812 Cochem (DE)
(72) Erfinder:
(74) Vertreter: Hannke, Christian

(56) Entgegenhaltungen:
- EP-A1- 2 224 162
- WO-A1-2012/157075
- WO-A1-2013/080836
- WO-A2-2012/138658
- WO-A2-2012/170609
- DE-A1- 10 306 720
- DE-A1-102007 015 472
- DE-U1-202006 005 427
- DE-U1-202007 008 574
- DE-U1-202012 006 496
- KR-A- 20100 001 551
- US-A1- 2006 123 679
- US-A1- 2009 229 154
- US-A1- 2011 252 678
- US-A1- 2012 241 731

## Beschreibung

Die Erfindung betrifft ein Flächenelement zum Leuchten und Speichern von Energie.

Althergebracht für Werbeanwendungen sind Litfasssäulen und Plakatwände. Auch wenn diese sich bereits über Jahrzehnte bewährt haben, mittels moderner Klebe- und Druckverfahren austauschbar sind, so hat sich im Zeitalter der digitalen Meiden eine starke Suche nach Alternativen eingestellt. Nun gibt es Leuchtbilder mit Neonröhren oder LEDs. In der Regel benötigen solche jedoch Strom- und Kabelanschlüsse, weisen ein hohes Gewicht auf und sind schwierig zu installieren. Zudem ist eine Änderung der Werbebotschaft nur sehr schwierig zu realisieren. Flachbildschirme und Beamer-Leinwände zieren mittlerweile auch viele Plätze und dienen der austauschbaren Werbeanwendung oder der Ankündigung von Veranstaltungen. Für Werbebotschaften ist es jedoch nicht immer notwendig, direkt einen kompletten Flachbildschirm bereitzustellen. Realisiert sind auch Standardsolarzellen mit LEDs und mittels Laser herausgeschnittenen Beschriftungen. Solche Produkte sind recht teuer, eintönig und schwer sowie mehrere Zentimeter dick.

Die Druckschrift WO 2013/080836 beschreibt eine Beleuchtungseinheit mit Tagseite und gegenüberliegender Nachtseite. An der Tagseite kann eine Batterie über ein Solarmodul geladen werden; an der Nachtseite kann mittels in der Batterie gespeicherter Energie Licht erzeugt werden. Nachteilig an der beschriebenen Beleuchtungseinheit ist, dass sowohl Solarschicht als auch Leuchtschicht und Batterie makroskopische Größen aufweisen und aufwändig miteinander verbunden werden müssen.

Die Druckschrift DE 20 2012 006496 U1 offenbart eine Leuchte mit einer Lichtquelle, einem Solarelement und einem dazwischen angeordneten Akkumulator, die in Sandwich-Bauweise miteinander verbunden sind. Wie bei der Beleuchtungseinheit gemäß WO 2013/080836 ergeben sich auch hier die Nachteile makroskopischer Bauteile und einer aufwändigen Verbindung derselben.

Die Druckschrift KR 2010 0001551 A beschreibt ein Siebdruck-Verfahren zum Aufdrucken einer Leuchtschicht aus einem organischen Material. Mit dem beschriebenen Verfahren könnte also eine Leuchtschicht auf einfache Weise auf einem Substrat aufgebracht und mit diesem verbunden werden. KR 2010 0001551 A enthält jedoch keine Hinweise darauf, wie eine gegenüber dem vorgenannten Stand der Technik verbesserte Batterie bzw. ein Akkumulator hergestellt werden könnte.

Aus dem firmeninternen Stand der Technik ist ein Flächenelement zum Leuchten und Heizen bekannt. Es wird auf Anmeldung DE 10 2013 016 158.4 verwiesen.

Das Flächenelement zum Leuchten und Heizen besteht im Wesentlichen aus einem Multilayer, der wenigstens eine Beleuchtungsschicht und wenigstens eine Heizschicht sowie eine zwischen diesen angeordnete Isolierungsschicht und/oder Keramikschicht aufweist. Die wenigstens eine Beleuchtungsschicht besteht dabei aus einer transparenten Frontelektrodenschicht und einer Backelektrodenschicht mit dazwischen angeordneter Leuchtschicht und Dielektrikumsschicht. Dabei ist zwischen der Frontelektrodenschicht und der Backelektrodenschicht eine Leuchtspannung und an die wenigstens eine Heizschicht eine Heizspannung anlegbar.

Durch diese Ausgestaltung ist es ermöglicht, ein sehr breit einsetzbares Flächenelement zur Verfügung zu stellen, mit dessen Hilfe sowohl Leucht- als auch Heizfunktionen übernommen werden können. Dabei ist das Flächenelement in seiner geometrischen Form nicht auf eine ebene Fläche beschränkt. Vielmehr können auch Flächenelemente hergestellt werden, die eine gekrümmte Fläche beziehungsweise sogar eine mehrfach gekrümmte Fläche aufweisen. Vorteilhaft dabei ist insbesondere auch, dass solche Flächenelemente an räumliche Gegebenheiten vor Ort angepasst werden können und somit platzsparend installiert werden können. Insbesondere bei einem geringen Raumangebot ist eine solche Ausgestaltung eines erfindungsgemäßen Flächenelementes sehr vorteilhaft, da es räumlich nur sehr wenig Platz benötigt und keine separaten Beleuchtungs- und Heizeinrichtungen installiert werden müssen. Die Energieversorgung ist dabei in der Regel derart ausgestaltet, dass sowohl die Heizspannung als auch die Leuchtspannung in einem Bereich zwischen 12 Volt und 300 Volt liegt. Allerdings sind auch andere Spannungsbereiche denkbar. Die zu verwendenden Spannungen richten sich in der Regel nach dem Anwendungsbeispiel und den Dimensionen der Leucht- und Heizschicht.

Grundsätzlich ist es möglich, ein erfindungsgemäßes Flächenelement auf jeglicher Art von Oberfläche aufzubringen, beispielsweise auf Oberflächen aus Glas, Papier, Plastik, Granit, Metall oder dergleichen. Insofern würden die einzelnen Schichten in der entsprechenden Reihenfolge auf die jeweilige Oberfläche aufgebracht, wobei die Beleuchtungsschicht die äußere Schicht bildet und in Richtung des Raumes angeordnet ist, der durch die Beleuchtungsschicht ausgeleuchtet werden soll. Die äußere zum auszuleuchtenden Raum hinweisende Schicht der Beleuchtungsschicht ist dabei die transparente Frontelektrodenschicht, auf der gegebenenfalls noch eine transparente Substratschicht zum Schutz der Frontelektrodenschicht aufgebracht ist.

Es ist allerdings auch möglich, das erfindungsgemäße Flächenelement mit seinen Schichten nicht direkt auf die zu beschichtende Oberfläche aufzubringen. Vielmehr kann die Beleuchtungsschicht und die Heizschicht auch auf eine Substratschicht aufgebracht werden, sodass ein folienartiges Flächenelement gegeben ist. Ein solches folienartiges Flächenelement ist in seiner Anwendung sehr breit einsetzbar, da es in seiner Ausgestaltung absolut biegsam ist und auf die verschiedensten Arten von Oberflächen aufbringbar ist. Daraus ergeben sich hervorragende Einsatzmöglichkeiten in vielen Bereichen des täglichen Lebens, wie beispielsweise beim Hausbau oder auch in der Automobilindustrie und/oder dergleichen.

### Besonders vorteilhaft ist es, wenn

i) die Beleuchtungsschicht zwischen 8,05 µm und 120 µm stark ist, wobei vorzugsweise
   a) die transparente Frontelektrodenschicht zwischen 0,05 µm und 5 µm,
   b) die Backelektrodenschicht zwischen 4 µm und 45 µm,
   c) die Leuchtschicht zwischen 2 µm und 30 µm und
   d) die Dielektrikumsschicht zwischen 4 µm und 45 µm stark ist,
ii) die Heizschicht zwischen 6 µm und 60 µm stark ist und/oder
iii) die Isolierungsschicht zwischen 1 µm und 15 µm und die Keramikschicht (9) zwischen 3 µm und 30 µm stark ist.

Solche Schichten lassen sich mit herkömmlichen Verfahren in einfacher Weise herstellen und auf entsprechende Oberflächen aufbringen. Beispielhaft seien hier nur verschiedene Druckverfahren genannt, wie beispielsweise Siebdruck oder auch Offsetdruck.

Um aber eine biegsame Folie herzustellen, die möglichst in vielen Anwendungsbereichen eingesetzt werden kann, hat es sich als besonders vorteilhaft erwiesen, dass die separate Substratschicht zwischen 10 µm und 1000 µm stark ist. Durch diese Ausgestaltung der Erfindung erhält man eine dünne Folie, welche maximal im Bereich von 1 mm stark ist und die auf entsprechenden Oberflächen angeordnet werden kann.

Dabei hat es sich weiterhin bewährt, dass die Frontelektrodenschicht Silber-Nano-Wires, Carbon-Nano-Tubes, PEDOT/PSS Materialien (Materialien aus mit Polystyrolsulfonat dotiertem Poly-3,4-ethylendioxythiophen), ITO-Pigmente (Pigmente aus Indiumzinnoxid), Zinkoxid, Aluminiumoxid, organische Lösungen, Emulsierer, Verdicker, Verdünner, Konditionierer, Viskositätsmittel, Kleber, Anti-Oxidanzmittel und/oder dergleichen Materialien enthält. Solche Materialien eignen sich besonders gut für die Anwendung als Frontelektrodenschicht, da sie sehr lichtdurchlässig sind, und somit nur ein sehr geringer Anteil des durch die Leuchtschicht erzeugten Lichtes von der Frontelektrodenschicht absorbiert wird. Das von der Leuchtschicht emittierte Licht kann somit im Wesentlichen verlustfrei die Frontelektrodenschicht passieren und zur Ausleuchtung des Raumes genutzt werden.

Da es bei der Backelektrodenschicht nicht notwendig ist, dass diese transparent ist, enthält die Backelektrodenschicht Silber, Kupfer, Zinn, Zink, Carbon, PEDOT/PSS Materialien (Materialien aus mit Polystyrolsulfonat dotiertem Poly-3,4-ethylendioxythiophen), Zinkoxid, Aluminiumoxid, organische Lösungen, Emulsierer, Verdicker, Verdünner, Konditionierer, Viskositätsmittel, Kleber, Anti-Oxidantmittel und/oder dergleichen Materialien. Die Backelektrodenschicht und die Frontelektrodenschicht weisen durch die Materialeigenschaften der eingesetzten Materialien die für die Nutzung als Elektrode notwendigen elektrischen und/oder elektronischen Eigenschaften auf, sodass die Beleuchtungsschicht mit diesen Elektroden sehr effizient betrieben werden kann.

Zur Verwendung in der Leuchtschicht haben sich insbesondere Nano-Zinksulfid, Europium, Siliziumnitrid, organische Lösungen, Emulsierer, Verdicker beziehungsweise Verdünner, Konditionierer, Viskositätsmittel, Kleber, Anti-Oxidantmittel und/oder dergleichen Materialien als besonders sinnvoll erwiesen. Insbesondere haben sich hier organische Lösungen als besonders geeignet erwiesen, da diese sehr energieeffizient, beispielsweise als organische Leuchtdioden, das entsprechende Licht zur Ausleuchtung des Raumes erzeugen. Hiermit kann die Leuchtschicht beziehungsweise die Beleuchtungsschicht sehr energieeffizient betrieben werden, wobei annähernd die gesamte elektrische Energie, die über die Leuchtspannung der Beleuchtungsschicht zugeführt wird, in Lichtenergie umgewandelt wird.

Die Dielektrikumsschicht enthält Bariumtitanat, Isoliermittel, organische Lösungen, Emulsierer, Verdicker beziehungsweise Verdünner, Konditionierer, Viskositätsmittel, Kleber, Anti-Oxidantmittel und/oder dergleichen Materialien.

Die Heizschicht enthält im Wesentlichen Carbon-Nano-Tubes, organische Lösungen, Emulsierer, Verdicker, Verdünner, Konditionierer, Viskositätsmittel, Kleber, Anti-Oxidantmittel und/oder dergleichen Materialien. Die hier als Heizschicht eingesetzten Materialien wandeln nahezu 100 % der über die Heizspannung eingespeisten elektrischen Energie in Wärme um. Somit kann durch das erfindungsgemäße Flächenelement eine Maximaltemperatur oberhalb von 200 °C (523 K) erzeugt werden.

Zwischen der Heizschicht und der Beleuchtungsschicht ist vorzugsweise noch eine Isolierungsschicht angeordnet, um eine elektronische/elektrische Trennung zwischen diesen Schichten zu erreichen. Die Isolierungsschicht enthält im Wesentlichen PET, PVC, organische Lösungen, Emulsierer, Verdicker, Verdünner, Konditionierer, Viskositätsmittel, Kleber, Anti-Oxidantmittel und/oder dergleichen Materialien.

Ferner kann zwischen Beleuchtungsschicht und Heizschicht noch eine Keramikschicht vorgesehen sein. Die Keramikschicht enthält im Wesentlichen Nano-Keramiken, organische Lösungen, Emulsierer, Verdicker, Verdünner, Konditionierer, Viskositätsmittel, Kleber, Anti-Oxidantmittel und/oder dergleichen Materialien und dient aufgrund ihrer guten Wärmeleitfähigkeit im Wesentlichen dazu, die durch das Heizelement erzeugte Wärme besser an die Raumumgebung abzugeben.

Die Substratschicht enthält im Wesentlichen Glas, Papier, Kunststoff, Granit, Metall und/oder dergleichen Materialien. Aus solchen Materialien können sehr dünne Substratschichten hergestellt werden, sodass Flächenelemente in Form von vorzugsweise biegsamen Folien für alle möglichen Anwendungen in einfacher Weise hergestellt werden können. Solche biegsame Folien können auf vielen möglichen Oberflächen angeordnet und dort zum Heizen und Ausleuchten von Räumen genutzt werden.

Ferner sind auch Schalter und/oder Regeleinrichtungen vorgesehen, mit denen die Heizspannung und die Leuchtspannung ein- und ausschaltbar und regelbar sind, wobei die Schalter und/oder Regeleinrichtungen als externe Elemente oder aber als interne integrierte oder externe Elemente, wie beispielsweise Helligkeitsmesser, Bewegungssensoren, Zeitschaltuhren, Dimmer und/oder Temperaturmesser und/oder dergleichen, ausgebildet sind.

Vorteilhafterweise ist die Leuchtschicht zum Leuchten mit einer Leuchtdichte von bis zu 500 cd/m² vorzugsweise zum flimmer- und/oder blendfreien und besonders bevorzugt zum Leuchten in verschiedenen Farben ausgebildet.

Denkbar ist, dass die Heizschicht zum Heizen bis maximal 523 K ausgebildet ist.

Grundsätzlich können die einzelnen Schichten des erfindungsgemäßen Flächenelementes zum Leuchten und zum Heizen als Paste vorliegen, welche beispielsweise mit einem Siebdruckverfahren auf jegliches Material aufgetragen werden, welches nach Bedruckung mit den Pasten leuchtet und heizt. Der Vorteil des erfindungsgemäßen Flächenelementes ist, dass die Beschichtungen absolut biegsam sind und eine Dicke von unter einem Millimeter erlauben. Die Größe der Beschichtung ist dabei nicht begrenzt. Ein weiterer Vorteil ist, dass das Licht sehr gleichmäßig blend- und flimmerfrei bei sehr geringem Stromverbrauch in definierbaren Farben leuchtet. Es sind Leuchtdichten bis zu 500 cd/m² denkbar. Die Heizbeschichtung setzt nahezu 100 % der elektrischen Energie in Wärme um und kann Maximaltemperaturen oberhalb von 200 °C (523 K) erzeugen. Ebenso ist das entwickelte Flächenelement zum Heizen und Leuchten für Indoor- und Outdoorbenutzung geeignet. Es verträgt Nässe und Feuchtigkeit. Auch unter Wasser kann die Beschichtung eingesetzt werden. Der Temperaturbereich kann zwischen minus 45° C (228 K) und plus 150° C (423 K) liegen. Die Betriebsdauer ist extrem lange und liegt derzeit bei mehreren 1000 Stunden. Der Vorteil des erfindungsgemäßen Flächenelementes liegt weiter im optimierten Materialeinsatz der Energie umwandelnden Schichten. Dadurch ist es erstmals möglich, derartige Kombiprodukte mittels eines einfachen Herstellungsverfahrens, beispielsweise eines Siebdruckprozesses herzustellen. Durch die Kombination von Heiz- und Leuchtfunktionen sind Gewichtsvorteile und Preisvorteile immer dann vorhanden, wenn man Licht und Heizung an einem Ort einsetzen will oder muss.

Der Erfindung liegt die Aufgabe zugrunde, ein Flächenelement zum Leuchten und Speichern von Energie zu schaffen, welches leicht, kostengünstig und sehr dünn ist.

Gelöst wird diese Aufgabe durch ein Flächenelement zum Leuchten und Speichern von Energie mit sämtlichen Merkmalen des Patentanspruches 1. Ferner wird die Aufgabe auch durch ein Verfahren zum Herstellen eines Flächenelements mit sämtlichen Merkmalen des Patentanspruches 11 gelöst. Vorteilhafte Ausgestaltungen finden sich in den Unteransprüchen.

Das erfindungsgemäße Flächenelement zum Leuchten und Speichern von Energie weist einen Multilayer auf, der wenigstens eine Beleuchtungsschicht zum Leuchten, wenigstens eine Akkuschicht zum Speichern von Energie und wenigstens ein Trägerelement als Unterlage zum Aufdrucken der anderen Schichten umfasst, wobei die wenigstens eine Beleuchtungsschicht und die wenigstens eine Akkuschicht wenigstens abschnittsweise übereinander auf das wenigstens eine Trägerelement mittels Siebdruck aufgedruckt sind.

Unter einem Multilayer ist dabei eine Folge von mehreren Schichten zu verstehen. Als Trägeelement ist eine Schichtunterlage aus Keramikvlies, PET-Folie, Papier, Spezialfolien wie beispielsweise Kapton, Navion von Dupont, Acryl, Plexiglas, Makrolon, Glas, Granit, Metall oder dergleichen. Dabei ist sowohl denkbar, dass das Trägerelement der Akkuschicht zugewandt ist, als auch, dass das Trägerelement der Beleuchtungsschicht zugewandt ist. Vorteilhaft sind die Schichten flächendeckend direkt übereinander angeordnet. Denkbar ist jedoch eine mittelbare Anordnung mit wenigstens einer Zwischenschicht. Möglich sind jedoch beliebig viele Schichten. Vorteilhaft ist das Trägerelement als rechteckige Schicht ausgebildet. Jedoch sind auch beliebige andere Formen denkbar. Besonders vorteilhaft ist das Trägerelement als Folie ausgebildet. Dies ist vorteilhaft, da sich auf diese Weise ein besonders leichter Aufbau ergibt, der an jedem beliebigen Untergrund passbar ist.

Die Akkuschicht weist wenigstens zwei bedruckte Substratschichten, dazwischen wenigstens einen Separator mit einem Elektrolyten und an den Außenseiten je wenigstens eine Verkapselungsschicht auf. Vorteilhaft ist die Verkapselungsschicht jeweils als Isolationsschicht ausgebildet. Die Substratschichten sind vorteilhaft aus einem Folienmaterial ausgebildet. Denkbar sind jedoch beliebige Materialien, die auch für das Trägerelement in Frage kommen. Als Materialien für die Akkuschicht sind u. a. Graphen, Graphit, organische Lösungen, Emulgierer, Verdicker oder Verdünner, Konditionierer, Viskositätsmittel, Kleber sowie Antioxidanzmittel denkbar. Die Akkuschicht ist als Superkondensator, auch Ultrakondensator genannt, ausgebildet.

Die Schichtdicken der Akkuschicht betragen für die Verkapselung 20 bis 250 Mikrometer, für das bedruckte Substrat 3 bis 250 Mikrometer und für den Separator inklusive Elektrolyten 500 Nanometer bis 250 Mikrometer.

Ferner ist denkbar, dass das Trägerelement transparent ausgebildet ist. Dies ist besonders vorteilhaft, um durchlässig für das Licht einer Leuchtschicht zu sein. Denkbar ist jedoch auch ein nicht transparentes Trägerelement.

Denkbar ist, dass die Beleuchtungsschicht eine gesamtflächige monochrome Beleuchtung darstellt. Vorteilhaft ist eine segmentierte Beleuchtungsschicht, der wenigstens ein Teilflächensegment zum Leuchten anregbar ist. Dabei ist denkbar, dass ein Teilflächensegment die Form einer Werbeabbildung, eines Buchstabensegmentes oder Zeichensegmentes aufweist.

Auf diese Weise ist das Segment als leuchtendes Werbeelement oder Hinweiselement verwendbar. Insbesondere ist eine Zusammensetzung der Beleuchtungsschicht aus mehreren separat ansteuerbaren Leuchtsegmenten denkbar. Dies ist vorteilhaft, da auf diese Weise das Flächenelement verschiedene Leuchtformen darstellen kann. Zum Ansteuern ist dabei eine Elektronikplatine denkbar, die als weitere Schicht angrenzend zu der Beleuchtungsschicht angeordnet ist und Kontakte zu den einzelnen Teilflächensegmenten der Beleuchtungsschicht aufweist. Dies ist vorteilhaft, da auf diese Weise die Steuerung direkt in das Flächenelement eingebaut ist.

In einer weiteren vorteilhaften Ausführungsform weist die wenigstens eine Beleuchtungsschicht eine Frontelektrodenschicht und eine Backelektrodenschicht mit dazwischen angeordneter Leuchtschicht und Dielektrikumsschicht auf, wobei zwischen Frontelektrodenschicht und Backeletrodenschicht eine Leuchtspannung anlegbar ist. Vorteilhafte Materialien für die Frotnelektrodenschicht, die Backelektrodenschicht, die Leuchtschicht sowie die Dielektrikumsschicht entsprechen den Materialien dieser Schichten bei dem Flächenelement zum Leuchten und Heizen. Auch vorteilhafte Dicken dieser Schichten entsprechen den vorteilhaften Dicken bei dem Flächenelement zum Leuchten und Heizen. Dieser Vierschichtaufbau ist besonders vorteilhaft. Zum effektiven Ausnutzen des Elektrolumineszenzeffektes dient die Dielektrikumsschicht zum Anpassen einer Kapazität. Besonders bekannt ist der Elektrolumineszenzeffekt an Zinksulfid, das durch eine hochfrequente Wechselspannung zum Leuchten anregbar ist. Durch die Frontelektrodenschicht und die Backelektrodenschicht kann die Wechselspannung auf die Leuchtschicht übertragen werden. Denkbar ist, dass beide Schichten nur einen Anschluss aufweisen, so dass eine von außen angelegte Wechselspannung effektiv übertragen wird. Dies ist vorteilhaft aufgrund der Einfachheit. Vorteilhaft ist jedoch denkbar, dass beispielsweise eine Platine angrenzend zu der Backelektrodenschicht angeordnet ist, die eine Auswahl der zu steuernden Leuchtsegmente der Leuchtschicht erlaubt, wobei jedoch die Frontelektrodenschichten der verschiedenen Leuchtsegmente miteinander in Verbindung stehen. Das Flächenelement ist jedoch nicht auf die genannten Varianten beschränkt.

In einer weiteren vorteilhaften Ausführungsform umfasst das Flächenelement weiterhin eine Energiewandlereinheit zum Umwandeln von eingestrahlter Lichtenergie in elektrische Energie. Dies ist vorteilhaft, da auf diese Weise beispielsweise eingestrahltes Sonnenlicht als elektrische Energie in der Akkuschicht gespeichert werden kann und anschließend zum Beleuchten der Beleuchtungsschicht Verwendung finden kann.

Bei einer weiteren vorteilhaften Ausführungsform ist die Energiewandlereinheit als transparente Schicht ausgebildet, insbesondere derart, dass übereinander auf die wenigstens eine Akkuschicht mittelbar oder unmittelbar die wenigstens eine Beleuchtungsschicht folgt und auf die wenigstens eine Beleuchtungsschicht mittelbar oder unmittelbar die wenigstens eine Energiewandlereinheit folgt. Dies ist vorteilhaft, da auf diese Weise die Energiewandlereinheit dem eingestrahlten Licht zugewandt werden kann. Da die Energiewandlerschicht transparent ausgebildet ist, kann sie bei Abnahme des einstrahlenden Lichtes zum Beispiel in der Abenddämmerung als durchlässige Schicht für das Licht der Beleuchtungsschicht Verwendung finden. Dabei ist denkbar, dass eine Durchkontaktierung zwischen Energiewandlerschicht und Akkuschicht durch die Beleuchtungsschicht hindurch das Übertragen der in der Energiewandlerschicht erzeugten elektrischen Energie in die Akkuschicht ermöglicht. Der weitere Kontraktierung ermöglicht vorteilhaft das Freisetzen der in der Akkuschicht gespeicherten Energie für die Anregung der Beleuchtungsschicht.

In einer weiteren vorteilhaften Ausführungsform ist die wenigstens eine Energiewandlereinheit nicht transparent ausgebildet, bevorzugt derart, dass wenigstens eine kombinierte Schicht des Flächenelementes aus einem als Beleuchtungsschicht ausgebildeten Teilflächenbereich und einem als Energiewandlereinheit ausgebildeten Teilflächenbereich ausgebildet ist, besonders bevorzugt derart, dass übereinander auf die wenigstens eine Akkuschicht mittelbar oder unmittelbar wenigstens die eine kombinierte Schicht folgt. Die Teilflächenbereiche der Energiewandlereinheit und der Beleuchtungsschicht sind dabei in Erstreckungsrichtung der Schichten nebeneinander angeordnet. Dies ist besonders vorteilhaft, da auf diese Weise keine weitere Schicht angrenzend zu der Beleuchtungsschicht angeordnet ist, welche das abstrahlende Licht dämpfen würde. Weiterhin sind firmenintern bekannte Energiewandlereinheiten, die nicht transparent ausgebildet sind, effektiver und weisen einen größeren Wirkungsgrad gegenüber transparenten Energiewandlereinheiten auf. Nachteilig dabei ist jedoch, dass nicht die ganze Fläche des Flächenelementes für die Energiewandlereinheit und die Beleuchtungsschicht zur Verfügung steht. Vorteilhaft ist jedoch, dass die Akkuschicht sowohl angrenzend zu der Energiewandlerschicht als auch angrenzend zu der Beleuchtungsschicht anordbar ist, was in beiden Fällen einen besseren Energietransport ermöglicht.

In einer weiteren vorteilhaften Ausführungsform umfasst die Energiewandlereinheit übereinander wenigstens eine transparente Frontelektrodenschicht und/oder danach mittelbar oder unmittelbar wenigstens eine Trägerstrukturschicht zur Stabilisierung des Flächenelementes und/oder danach mittelbar oder unmittelbar wenigstens eine Schicht solaraktives Material und/oder danach mittelbar oder unmittelbar wenigstens eine Transportschicht und/oder danach mittelbar oder unmittelbar wenigstens eine Backelektrodenschicht und/oder danach mittelbar oder unmittelbar wenigstens eine Verkapselungsschicht, wobei zwischen transparenter Frontelektrodenschicht und Backelektrodenschicht vorteilhaft eine Spannung anlegbar ist. Denkbar ist, dass dabei auf die Transportschicht und die Trägerstrukturschicht verzichtet wird. Dies ist vorteilhaft, da auf diese Weise eine besonders dünne Ausführungsform möglich ist. Nachteilig ist dabei jedoch, dass die Transportschicht für eine Aufrechterhaltung der Ladungstrennung besonders gute Eigenschaften aufweist. Zudem ist es denkbar, dass das solaraktive Material ohne eine stabilisierende Trägerstrukturschicht seine Wirkung einbüßt. Für die Trägerstrukturschicht sind Gläser, Plexiglas, Metallfolien, Plastikfolien und ähnliche flexible bzw. starre Substrate denkbar. Für die Transportschicht sind negative und positive Ausbildungen aus organischen und anorganischen Stoffen denkbar. Sie haben die Aufgabe, die Elektronen besser zu transportieren.

Vorteilhaft ist die Verkapselung als Isolationsschicht ausgebildet.

Die zur Backelektrode angrenzende Verkapselung weist vorteilhaft eine Dicke zwischen 500 Nanometer und 250 Mikrometer auf. Die Backelektrode weist vorteilhaft eine Dicke zwischen 100 Nanometer und 15 Mikrometer auf. Die Transportschicht weist vorteilhaft eine Dicke zwischen 50 Nanometer und 5 Mikrometer auf. Das solaraktive Material weist vorteilhaft eine Dicke zwischen 50 Nanometer und 5 Mikrobeter auf. Die Trägerstruktur weist vorteilhaft eine Dicke zwischen 100 Nanometer und 5 Mikrobeter auf. Die Frontelektrode weist vorteilhaft eine Dicke zwischen 100 Nanometer und 5 Mikrometer auf. Die zur Frontelektrode angrenzende Verkapselung weist vorteilhaft eine Dicke zwischen 20 und 250 Mirkometer auf.

In einer weiteren vorteilhaften Ausführungsform ist ein Helligkeitssensor, bevorzugt mit weiteren Regeleinheiten in dem Flächenelement integriert. Dies ist vorteilhaft, da auf diese Weise zwischen Akkuladungsbetrieb durch eine Energieumwandlerschicht und Leuchtbetrieb der Beleuchtungsschicht in Abhängigkeit von der Helligkeit automatisch umgeschaltet werden kann.

In einer weiteren vorteilhaften Ausführungsform sind die Verkapselungsschichten als Isolationsschichten ausgebildet und/oder das Flächenelement weist wenigstens eine weitere Zwischenschicht auf, bevorzugt ausgebildet als Isolationsschicht, als flexibles Substrat, als starres Substrat oder als gedruckte oder ungedruckte Elektronikschicht. Je nach Verwendungszweck können diese weiteren Schichten vorteilhaft angepasst, hinzugefügt oder weggelassen werden.

In einer weiteren vorteilhaften Ausführungsform ist das Flächenelement als Werbeschild, sowohl indoor als auch outdoor und/oder als Hinweisschild, z. B. als Verkehrsschild oder als Sicherheitsschild oder für einen Notausgang und/oder als Zuganzeigetafel ausgebildet. Jedoch ist die Verwendung nicht darauf beschränkt.

Weiterhin wird die Aufgabe erfindungsgemäß auch von einem Verfahren zum Herstellen eines Flächenelementes gelöst, wobei wenigstens eine der Schichten mittels Siebdruck auf das Trägerelement aufgedruckt wird. Der Vorteil des Siebdruckverfahrens ist, dass die optimalen Schichtdicken in der gewünschten Höhe sehr schnell aufgetragen werden können. Geschwindigkeiten von bis zu 400 m² pro Stunde sind mit der entsprechenden Druckmaschine möglich.

Als Materialien für die Einzelschichten der Energiewandlerschicht sind aktive Schichten, z. B. aus CEGS, CZTS, Peroskite, CsSnl 3 und andere organische sowie anorganische Schichten vorteilhaft denkbar.

Weiterhin ist auch wenigstens eine Keramikschicht als Zwischenschicht vorteilhaft denkbar. Besonders vorteilhaft besteht eine Keramikschicht aus Nanokeramiken, organischen Lösungen, Emulgierer, Verdicker, Verdünnern, Konditionierern, Viskositätsmitteln, Klebern, Antioxidantmitteln und/oder anderen Stoffen.

Die Leuchtdichten der Beleuchtungsschicht betragen vorteilhaft zwischen Candela pro m² bis 10.000 Candela pro m².

Die Energiedichten des Akkus liegen vorteilhaft zwischen 15 Wattstunden pro Kilogramm bis 800 Wattstunden pro Kilogramm.

Vorteilhaft sind die Flächenelemente in einem Temperaturbereich zwischen - 40° bis + 90° C einsatzbereit.

Für eine Durchkontaktierung zwischen verschiedenen Schichten ist ein kontaktierender Rahmen denkbar. Dies ist vorteilhaft, da so ein Innenbereich des Flächenelementes nicht betroffen ist. Ebenfalls sind jedoch auch Durchkontaktierungen im Mittenbereich denkbar. Ein Rahmen kann als Alu- oder Plastikrahmen beispielhaft ausgebildet sein. Als Steuerungselemente sind Helligkeitssensoren, Zeitschaltuhren oder ein Mikroschalter, wovon wenigstens ein Element vorteilhaft in das Flächenelement integriert ist, denkbar. Hierbei sind jedoch auch Elektronikschalter außerhalb des Flächenelementes möglich.

Weiter Ziele, Vorteile, Merkmale und Anwendungsmöglichkeiten der vorliegenden Erfindung ergeben sich aus den nachfolgenden Beschreibungen von Ausführungsbeispielen anhand der Zeichnungen. Es zeigen:
- Fig. 1: ein Ausführungsbeispiel aus dem firmeninternen Stand der Technik;
- Fig. 2: ein zweites Ausführungsbeispiel aus dem firmeninternen Stand der Technik;
- Fig. 3: schematischen Schichtenaufbau eines erfindungsgemäßen Flächenelementes mit Energiewandlereinheit, wobei die Trägerschicht angrenzend zur Akkuschicht angeordnet ist und die Energiewandlerschicht transparent ausgebildet ist;
- Fig. 4: schematischen Aufbau eines erfindungsgemäßen Flächenelementes mit einer transparenten Trägerschicht angrenzend zu einer kombinierten Schicht mit nicht transparenter Energiewandlerschicht und Beleuchtungsschicht;
- Fig. 5: schematischen Aufbau einer Akkuschicht;
- Fig. 6: schematischen Aufbau einer Energieumwandlerschicht;
- Fig. 7: schematischen Aufbau einer erfindungsgemäßen Beleuchtungsschicht und
- Fig. 8: schematischen Aufbau einer erfindungsgemäßen Beleuchtungsschicht mit angrenzender, als Substratschicht ausgebildetem Trägerelement;

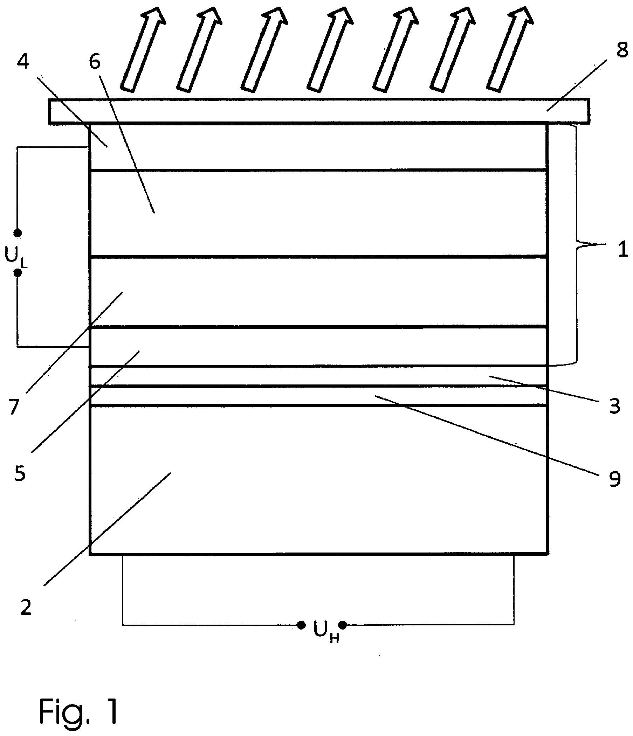

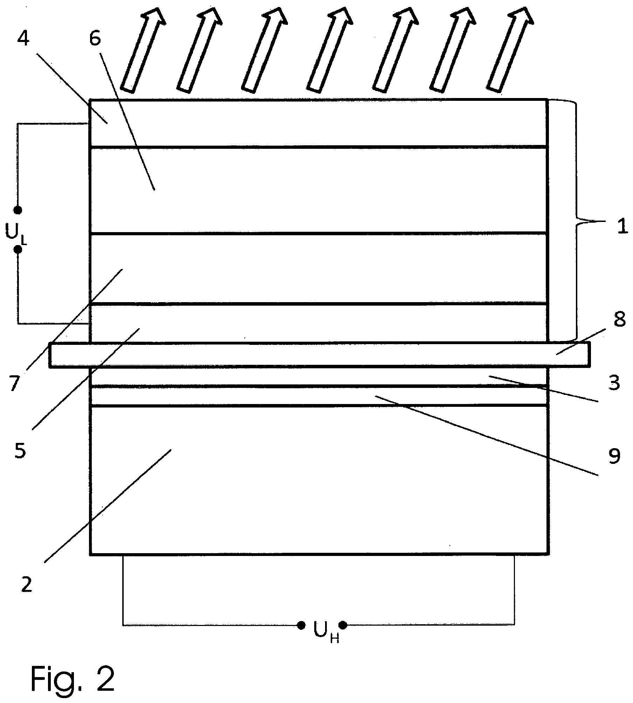

Die in den Figuren 1 und 2 dargestellten Ausführungsbeispiele zeigen Flächenelemente aus dem Stand der Technik, welche auf eine Substratschicht 8 aufgebracht sind.

Dabei wird in Figur 1 eine transparente Substratschicht 8 verwendet, auf welche eine transparente Frontelektrodenschicht 4 einer Beleuchtungsschicht 1 aufgebracht ist. Auf die Frontelektrodenschicht 4 ist weiterhin eine Leuchtschicht 6 und darauf eine Dielektrikumsschicht 7 aufgebracht. Die Beleuchtungsschicht 1 wird durch eine Backelektrodenschicht 5 abgeschlossen. Zwischen der Frontelektrode 4 und der Backelektrode 5 kann dabei eine Leuchtspannung U_{L} angelegt werden. Diese Leuchtspannung U_{L} kann je nach Schichtdicke und Anwendungsfall zwischen 12 Volt und 300 Volt liegen. Allerdings sind auch niedrigere und höhere Spannungen denkbar. Auf die Beleuchtungsschicht 1 beziehungsweise auf die Backelektrodenschicht 5 der Beleuchtungsschicht 1 ist weiterhin eine Isolierungsschicht 3 zur elektrischen/elektronischen Trennung der Beleuchtungsschicht 1 und einer noch folgenden Heizschicht 2 aufgebracht, an die sich eine Keramikschicht 9 anschließt. Auf die Keramikschicht 9 ist abschließend die Heizschicht 2 angeordnet, an welche eine Heizspannung U_{H} anlegbar ist. Auch die Heizspannung U_{H} kann je nach Anwendungsfall unterschiedliche Spannungen annehmen, liegt aber bevorzugt im Bereich zwischen 12 Volt und 300 Volt.

Im Gegensatz zu Figur 1 ist in Figur 2 eine nicht transparente Substratschicht 8 vorhanden, auf die auf der einen Seite die Beleuchtungsschicht 1 mit der transparenten Frontelektrode 4 und der Backelektrode 5 angeordnet ist, zwischen denen wiederum eine Leuchtschicht 6 und eine Dielektrikumsschicht 7 eingebracht sind. Auf der anderen Seite der Substratschicht 8 ist wiederum zur elektrischen/elektronischen Trennung der Beleuchtungsschicht 1 und der Heizschicht 2 eine Isolierungsschicht 3 angeordnet. Zwischen Isolierungsschicht 3 und Heizschicht 2 ist auch in diesem Ausführungsbeispiel eine Keramikschicht 9 angeordnet, durch welche die durch die Heizschicht 2 erzeugte Wärme besser an die Umgebung abgegeben werden kann.

Grundsätzlich können die in den Figuren 1 und 2 dargestellten Ausführungsbeispiele des erfindungsgemäßen Flächenelementes durch Siebdruckverfahren hergestellt werden, wobei die Ausgangsmaterialien der einzelnen Schichten als Pasten vorliegen. Dabei hat es sich bewährt, die in der Beschreibungseinleitung genannten Materialien für die einzelnen Schichten einzusetzen, wobei vorteilhafterweise die Pasten zur Herstellung der einzelnen Schichten alle Nanopartikel aufweisen.

Insbesondere besteht in den Ausführungsbeispielen der Figuren 1 und 2 die Substratschicht 2 aus einem Kunststoff, die Frontelektrodenschicht 4 aus PEDOT/PSS, die Leuchtschicht 6 aus einer organischen Lösung, die Dielektrikumsschicht 7 aus Bariumtitanat, die Backelektrodenschicht 5 aus Silber, die Isolierschicht 3 aus PVC, die Keramikschicht 9 aus Nanokeramiken und die Heizschicht 2 aus Carbon-Nano-Tubes.

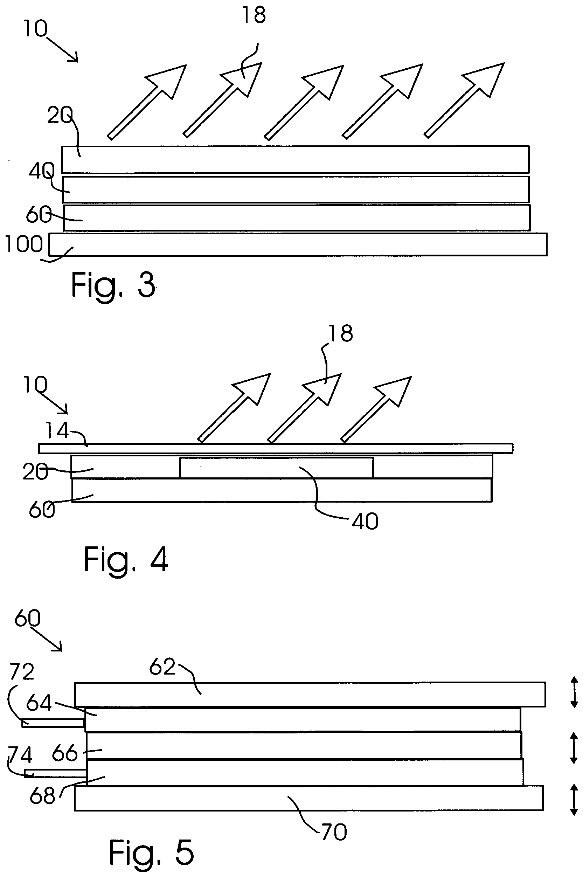

Fig. 3 und 4 zeigen zwei beispielhafte Ausführungsformen für ein erfindungsgemäßes Flächenelement 10 zum Leuchten und Speichern von Energie. Fig. 3 zeigt dabei ein Flächenelement 10 mit einer transparenten Energiewandlereinheit 20. Auf einem Trägerelement 100 ist zunächst eine Akkuschicht 60 angeordnet. Darüber befindet sich eine Beleuchtungsschicht 40 und darüber die Energiewandlereinheit 20. Das Flächenelement 10 ist in einem Beleuchtungsmodus gezeigt. Das von der Beleuchtungsschicht 40 emitierte Licht 18 ist in Form von Pfeilen dargestellt. Denkbar ist jedoch auch, dass das Trägerelement 100 auf der Seite der Energiewandlereinheit 20 als transparente Substratschicht angeordnet ist. Eine solche Anordnung ist beispielsweise in Fig. 4 gezeigt, jedoch mit einer nicht transparenten Energiewandlereinheit 20. Bezugszeichen werden dabei nicht notwendig neu erläutert. Hier ist die Beleuchtungsschicht 40 mit der Energiewandlereinheit 20 als kombinierte Schicht ausgebildet. Das Trägerelement 14 ist angrenzend zu der kombinierten Schicht angeordnet. Auch hier ist denkbar, dass das Trägerelement 14 angrenzend zu der Akkuschicht 60 angeordnet ist. Je nach dem, auf welcher Seite das Trägerelement angeordnet ist, ändert sich die Reihenfolge, in der die Schichten aufgedruckt werden.

Fig. 5 zeigt eine beispielhafte Akkuschicht 60. Ein Separator 66 inklusive Elektrolyt ist von zwei Schichten bedrucktem Substrat 64, 68 umgeben. Auf einer Seite befindet sich ein Plus-Anschluss 72, auf der anderen Seite ein Minus-Anschluss 74. Die beiden bedruckten Substratschichten 64, 68 sind von Verkapselungsschichten 62, 70 umgeben.

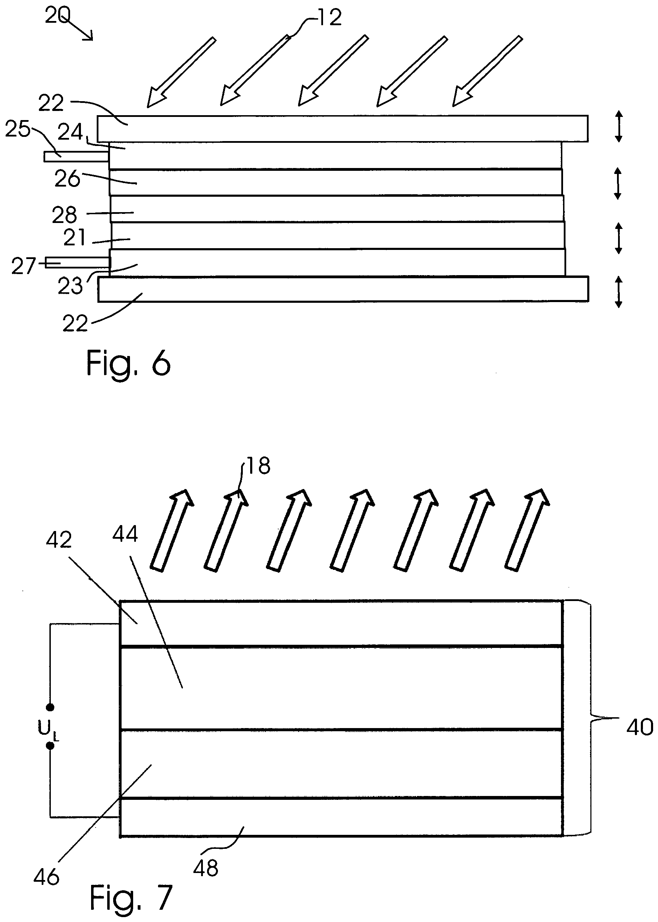

Fig. 6 zeigt eine beispielhafte Energiewandlerschicht 20. Diese ist im Einstrahlungsmodus gezeigt. Bezugszeichen 12 stellt in Form von Pfeilen das einstrahlende Licht 12 dar. Auf der dem einstrahlendem Licht 12 zugewandten Seite befindet sich eine transparente Verkapselung 22. Auf der gegenüber liegenden Seite befindet sich ebenfalls eine Verkapselung 22, welche sowohl transparent als auch nicht transparent ausgebildet sein kann. Angrenzend zu der dem einstrahlenden Licht 12 zugewandten Verkapselung 22 befindet sich eine transparente Frontelektrode 24 mit einem Elektrodenanschluss 25. Angrenzend zu der Frontelektrode 24 befindet sich eine Trägerstruktur 26, daran angrenzend ein solaraktives Material 28, daran angrenzend eine Transportschicht 21, daran angrenzend wiederum eine Backelektrode 23. Diese Backelektrode kann je nach Ausführungsform transparent oder nicht transparent ausgebildet sein und weist einen Minus-Anschluss 27 auf.

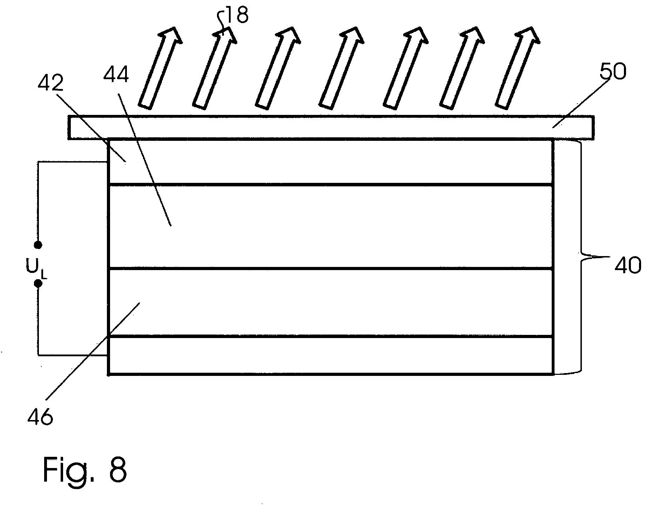

Fig. 7 und Fig. 8 zeigen jeweils einen Schichtaufbau einer Beleuchtungsschicht 40. Diese ist im Beleuchtungsmodus mit emittiertem Licht 18 gezeigt. Auf der Emissionsseite befindet sich eine Frontelektrodenschicht 42, daran angrenzend eine Leuchtschicht 44, daran angrenzend eine Dielektrikumsschicht 46 und daran angrenzend eine Backelektrodenschicht 48. Zwischen Frontelektrodenschicht 42 und Backelektrodenschicht 48 ist eine Spannung U_{L} anlegbar. In Fig. 8 ist auf der Emissionsseite angrenzend zu der Frontelektrodenschicht 42 ein Trägerelement 50 dargestellt, das als transparente Substratschicht ausgebildet ist.

### Bezugszeichenliste

- 1: Beleuchtungsschicht
- 2: Heizschicht
- 3: Isolierungsschicht
- 4: Frontelektrodenschicht
- 5: Backelektrodenschicht
- 6: Leuchtschicht
- 7: Dielektrikumsschicht
- 8: Substratschicht
- 9: Keramikschicht
- U_{H}: Heizspannung
- U_{L}: Leuchtspannung
- 10: Flächenelement
- 12: einstrahlendes Licht
- 14: Trägerelement
- 18: emittiertes Licht
- 20: Energiewandlereinheit
- 21: Transportschicht
- 22: Verkapselung
- 23: Backelektrode
- 24: Frontelektrode
- 25: Elektrodenanschluss
- 26: Trägerstrukturschicht
- 27: Minus-Anschluss
- 28: solaraktives Material
- 40: Beleuchtungsschicht
- 42: Fronelektrodenschicht
- 44: Leuchtschicht
- 46: Dielektrikumsschicht
- 48: Backelektrodenschicht
- 50: Trägerelement
- 60: Akkuschicht
- 62: Verkapselungsschicht
- 64: bedrucktes Substrat
- 66: Separator
- 68: Substratschicht
- 70: Verkapselungsschicht
- 74: Minus-Anschluss
- 100: Trägerelement

## Patentansprüche

1. Flächenelement (10) zum Leuchten und Speichern von Energie aufweisend einen Multilayer, der wenigstens eine Beleuchtungsschicht (40) zum Leuchten, wenigstens eine Akkuschicht (60) zum Speichern von Energie und wenigstens ein Trägerelement (100; 14) als Unterlage zum Aufdrucken der anderen Schichten umfasst,
**dadurch gekennzeichnet,dass**
die wenigstens eine Beleuchtungsschicht (40) und die wenigstens eine Akkuschicht (60) wenigstens abschnittsweise übereinander auf das wenigstens eine Trägerelement (100; 14) mittels Siebdruck aufgedruckt sind und die Akkuschicht (60) wenigstens zwei bedruckte Substratschichten, dazwischen wenigstens einen Separator mit einem Elektrolyten und an den Außenseiten je wenigstens eine Verkapselungsschicht aufweist und die Schichtdicken der Akkuschicht für die Verkapselung zwischen 20 und 250 Mikrometer, für das bedruckte Substrat 3 bis 250 Mikrometer und für den Separator inklusive Elektrolyten 500 Nanometer bis 250 Mikrometer betragen.

2. Flächenelement (10) nach Anspruch 1,
**dadurch gekennzeichnet, dass**
die wenigstens eine Beleuchtungsschicht (40) eine transparente Frontelektrodenschicht (42) und eine Backelektrodenschicht (48) mit dazwischen angeordneter Leuchtschicht (44) und Dielektrikumsschicht (46) aufweist und zwischen Frontelektrodenschicht (42) und Backelektrodenschicht (48) eine Leuchtspannung anlegbar ist.

3. Flächenelement (10) nach wenigstens einem der vorhergehenden Ansprüche,
**dadurch gekennzeichnet, dass**
das Flächenelement weiterhin wenigstens eine Energiewandler-Einheit (20) zum Umwandeln von eingestrahlter Lichtenergie in elektrische Energie umfasst.

4. Flächenelement (10) nach Anspruch 3,
**dadurch gekennzeichnet, dass**
die wenigstens eine Energiewandler-Einheit (20) als transparente Schicht ausgebildet ist, insbesondere derart, dass übereinander auf die wenigstens eine Akkuschicht (60) mittelbar oder unmittelbar die wenigstens eine Beleuchtungsschicht (40) folgt und auf die wenigstens eine Beleuchtungsschicht (40) mittelbar oder unmittelbar die wenigstens eine Energiewandler-Einheit (60) folgt.

5. Flächenelement (10) nach Anspruch 3,
**dadurch gekennzeichnet, dass**
die wenigstens eine Energiewandler-Einheit (60) nicht-transparent ausgebildet ist, bevorzugt derart, dass wenigstens eine kombinierte Schicht des Flächenelements aus einem als Beleuchtungsschicht (40) ausgebildeten Teilflächenbereich und einem als Energy-Harvest-Einheit (20) ausgebildeten Teilflächenbereich ausgebildet ist.

6. Flächenelement (10) nach wenigstens einem der Ansprüche 3 bis 5,
**dadurch gekennzeichnet, dass**
die Energiewandler-Einheit (20) übereinander wenigstens eine transparente FrontElektrodenschicht (24) und danach mittelbar oder unmittelbar wenigstens eine Trägerstrukturschicht (26) zur Stabilisierung des Flächenelements und danach mittelbar oder unmittelbar wenigstens eine Schicht solaraktives Material (28) und danach mittelbar oder unmittelbar wenigstens eine Transportschicht (21) und danach mittelbar oder unmittelbar wenigstens eine Back-Elektrodenschicht (23) und danach mittelbar oder unmittelbar wenigstens eine Verkapselungsschicht (22) umfasst.

7. Flächenelement (10) nach wenigstens einem der vorhergehenden Ansprüche,
**dadurch gekennzeichnet, dass**
ein Helligkeitssensor, bevorzugt mit weiteren Regeleinheiten in dem Flächenelement (10) integriert ist.

8. Flächenelement (10) nach wenigstens einem der vorhergehenden Ansprüche,
**dadurch gekennzeichnet, dass**
die Verkapselungsschichten (22, 62, 70) als Isolationsschichten ausgebildet sind und/oder das Flächenelement (10) wenigstens eine weitere Zwischenschicht aufweist.

9. Flächenelement (10) nach wenigstens einem der vorhergehenden Ansprüche,
**dadurch gekennzeichnet, dass**
das Flächenelement (10) als Werbeschild und/oder als Hinweisschild , insbesondere für einen Notausgang und/oder als Zuganzeigetafel ausgebildet ist.

10. Verfahren zum Herstellen eines Flächenelements (10) nach wenigstens einem der vorhergehenden Ansprüche,
**dadurch gekennzeichnet, dass**
wenigstens eine der Schichten mittels Siebdruck auf das Trägerelement (100; 14) aufgedruckt wird.

## Claims

1. Planar element (10) for lighting and for storage of energy, comprising a multilayer which has at least one illumination layer (40) for lighting, at least one accumulator layer (60) for storage of energy, and at least one carrier element (100; 14) as a base layer on which the other layers can be printed,
**characterised in that**
the at least one illumination layer (40) and the at least one accumulator layer (60) are at least in portions printed over each other onto the at least one carrier element (100; 14) by means of screen-printing, and the accumulator layer (60) has at least two printed substrate layers between which is arranged at least one separator with an electrolyte and on each outside of which is at least one encapsulation layer, and the layer thickness of the accumulator layer for the encapsulation is between 20 and 250 micrometres, for the printed substrate 3 to 250 micrometres, and for the separator including electrolytes 500 nanometres to 250 micrometres.

2. Planar element (10) according to claim 1, **characterised in that** the at least one illumination layer (40) has a transparent front electrode layer (42) and a back electrode layer (48), with a lighting layer (44) and a dielectric layer (46) arranged in between, and a lighting voltage can be applied between the front electrode layer (42) and the back electrode layer (48).

3. Planar element (10) according to at least one of the preceding claims, **characterised in that** the planar element furthermore comprises at least one energy conversion unit (20) for converting irradiated light energy into electrical energy.

4. Planar element (10) according to claim 3, **characterised in that** the at least one energy conversion unit (20) is configured as a transparent layer, in particular such that, over each other, the at least one illumination layer (40) follows directly or indirectly on the at least one accumulator layer (60), and the at least one energy conversion unit (60) follows directly or indirectly on the at least one illumination layer (40).

5. Planar element (10) according to claim 3, **characterised in that** the at least one energy conversion unit (60) is configured non-transparent, preferably such that at least one combined layer of the planar element is formed from a partial planar region configured as an illumination layer (40) and from a partial planar region configured as an energy harvesting unit (20).

6. Planar element (10) according to at least one of claims 3 to 5, **characterised in that** the energy conversion unit (20) comprises, over each other, at least one transparent front electrode layer (24), and then directly or indirectly at least one carrier structure layer (26) for stabilising the planar element, and then directly or indirectly at least one layer of solar-active Material (28), and then directly or indirectly at least one transport layer (21), and then directly or indirectly at least one back electrode layer (23), and then directly or indirectly at least one encapsulation layer (22).

7. Planar element (10) according to at least one of the preceding claims, **characterised in that** a brightness sensor, preferably with further control units, is integrated in the planar element (10).

8. Planar element (10) according to at least one of the preceding claims, **characterised in that** the encapsulation layers (22, 62, 70) are configured as isolation layers, and/or the planar element (10) comprises at least one further intermediate layer.

9. Planar element (10) according to at least one of the preceding claims, **characterised in that** the planar element (10) is configured as an advertising sign and/or an information sign, in particular for an emergency exit and/or as a train information display panel.

10. Method for producing a planar element (10) according to at least one of the preceding claims, **characterised in that** at least one of the layers is printed on the carrier element (100; 14) by means of screen-printing.

## Revendications

1. Elément de surface (10) destiné à éclairer et à stocker de l'énergie, comprenant une structure multicouches comprenant au moins une couche d'éclairage (40) destinée à éclairer, au moins une couche de stockage (60) destinée à stocker de l'énergie et au moins un élément de support (100 ; 14) en tant que support pour l'impression des autres couches,
**Caractérisé en ce que**
ladite au moins une couche d'éclairage (40) et ladite au moins une couche de stockage (60) sont imprimées par sérigraphie au moins en partie l'une au-dessus de l'autre sur ledit au moins un élément de support (100 ; 14), et la couche de stockage (60) comprend au moins deux couches de substrat imprimées, au moins un séparateur avec un électrolyte intercalé entre celles-ci et au moins une couche d'encapsulation sur chacune des faces extérieures, et l'épaisseur de la couche de stockage est comprise entre 20 et 250 micromètres pour l'encapsulation, entre 3 à 250 micromètres pour le substrat imprimé et entre 500 nanomètres et 250 microns pour le séparateur, électrolyte inclus.

2. Elément de surface (10) selon la revendication 1,
**Caractérisé en ce que**
ladite au moins une couche d'éclairage (40) comprend une couche d'électrode avant (42) transparente et une couche d'électrode arrière (48) avec une couche d'éclairage (44) et une couche diélectrique (46) intercalées entre celles-ci, et une tension lumineuse est applicable entre la couche d'électrode avant (42) et la couche d'électrode arrière(48).

3. Elément de surface (10) selon au moins une des revendications précédentes,
**Caractérisé en ce que**
l'élément de surface comprend en outre au moins une unité de conversion d'énergie (20) pour la conversion d'énergie lumineuse irradiée en énergie électrique.

4. Elément de surface (10) selon la revendication 3,
**Caractérisé en ce que**
ladite au moins une unité de conversion d'énergie (20) est prévue comme couche transparente, en particulier de telle manière que ladite au moins une couche d'éclairage (40) est directement ou indirectement superposée à ladite au moins une couche de stockage (60) et ladite au moins une unité de conversion d'énergie (20) est directement ou indirectement superposée à ladite au moins une couche d'éclairage (40).

5. Elément de surface (10) selon la revendication 3,
**Caractérisé en ce que**
ladite au moins une unité de conversion d'énergie (20) est prévue non transparente, préférentiellement de telle manière qu'au moins une couche combinée de l'élément de surface est composée d'une zone de surface partielle prévue comme couche d'éclairage (40) et d'une zone de surface partielle prévue comme unité de captage d'énergie (20).

6. Elément de surface (10) selon au moins une des revendications 3 à 5,
**Caractérisé en ce que**
l'unité de conversion d'énergie (20) comprend au moins une couche d'électrode avant (24) transparente, puis, directement ou indirectement superposée, au moins une couche de structure de support (26) pour la stabilisation de l'élément de surface, puis, directement ou indirectement superposée, au moins une couche de matériau de captage de rayonnement solaire (28), puis, directement ou indirectement superposée, au moins une couche de transport (21),puis, directement ou indirectement superposée, au moins une couche d'électrode arrière (23), puis, directement ou indirectement superposée, au moins une couche d'encapsulation (22).

7. Elément de surface (10) selon au moins une des revendications précédentes,
**Caractérisé en ce qu'**
un capteur de luminosité est intégré dans l'élément de surface (10), préférentiellement avec d'autres unités de régulation.

8. Elément de surface (10) selon au moins une des revendications précédentes,
**Caractérisé en ce que**
les couches d'encapsulation (22, 62, 70) sont réalisées comme couches isolantes et/ou l'élément de surface (10) comporte au moins une autre couche intercalée.

9. Elément de surface (10) selon au moins une des revendications précédentes,
**Caractérisé en ce que**
l'élément de surface (10) est réalisé comme panneau publicitaire et/ou panneau indicateur, en particulier pour une issue de secours et/ou comme tableau d'affichage de trains.

10. Procédé de fabrication d'un élément de surface (10) selon au moins une des revendications précédentes,
**Caractérisé en ce qu'**
au moins une des couches est imprimée par sérigraphie sur l'élément de support (100 ; 14).
